# EUROPÄISCHE PATENTSCHRIFT

(11) **EP 3 473 066 B1**
(45) Veröffentlichungstag und Bekanntmachung des Hinweises auf die Patenterteilung: **22.04.2026**
(21) Anmeldenummer: 17728826.3
(22) Anmeldetag: 08.06.2017
(51) Int. Cl.: B60Q 1/26, B60Q 1/30, B60Q 1/32, B60Q 3/78, F21S 43/15, F21S 45/50, H05K 1/18, H05K 3/28

(54) **LEUCHTE FÜR FAHRZEUGE**
LIGHT FOR VEHICLES
FEU DE VÉHICULES

(30) Priorität: 15.06.2016 DE 102016110936; 19.09.2016 DE 102016117576; 13.01.2017 DE 102017100606
(43) Veröffentlichungstag der Anmeldung: 24.04.2019
(73) Patentinhaber: ASPÖCK Systems GmbH, 4722 Peuerbach (AT)
(72) Erfinder: STEINER, Erwin, 4722 Peuerbach (AT)
(74) Vertreter: Söllner, Udo
(86) Internationale Anmeldenummer: PCT/EP2017/063904
(87) Internationale Veröffentlichungsnummer: WO 2017/216019

(56) Entgegenhaltungen:
- EP-A1- 2 454 520
- DE-A1- 102011 075 021
- DE-A1- 102013 208 400
- DE-B3- 102013 019 037
- US-A1- 2013 026 504

## Beschreibung

Die vorliegende Erfindung betrifft eine Leuchte für Fahrzeuge mit einer flexiblen Tragstruktur mit einer Rückseite und einer Vorderseite mit daran zumindest auf der Vorderseite angeordneten Leuchtmitteln in der Form von Leuchtdioden und einer die Tragstruktur zumindest abschnittsweise im Bereich der Leuchtdioden überspannenden lichtdurchlässigen Abdeckung nach dem Oberbegriff des Anspruchs 1.

Eine Leuchte für Fahrzeuge in der Form einer Kraftfahrzeug-Außenleuchte ist anhand der AT 516365 A1 bekannt geworden.

Diese bekannte Außenleuchte weist eine Tragstruktur zur Anordnung von Leuchtdioden als Leuchtmittel auf und besitzt eine die Leuchte vollständig überspannende Abdeckscheibe, die aus einem transparenten Material besteht und starr ausgebildet ist.

Eine mit den Leuchtdioden versehene Tragstruktur muss als Leuchteinheit in die Abdeckscheibe eingeformt werden, um die Außenleuchte auszubilden, was deutlich macht, dass es sich dabei um einen aufwendigen und kostenintensiven Vorgang handelt.

WO2011110217 A1 offenbart eine Leuchte mit einer flexiblen Leiterplatte und mit daran angeordneten Leuchtmitteln in der Form von Leuchtdioden, sowie einer im Bereich der Leuchtdioden überspannenden lichtdurchlässigen flexiblen Abdeckung. Im Bereich unter der Leiterplatte ist eine Leitungsanordnung in einem Gehäuse eingebettet, wobei die Leitungsanordnung Kabellitzen aufweist.

Aufgabe der vorliegenden Erfindung ist es, die Herstellung einer zu schaffenden Leuchte zu vereinfachen und die Leuchte kostengünstiger auszubilden.

Die Erfindung weist zur Lösung dieser Aufgabe die Merkmale nach dem Anspruch 1 auf, vorteilhafte Weiterbildungen hiervon sind in den weiteren Ansprüchen beschrieben.

Die Erfindung schafft eine Leuchte für Fahrzeuge, mit einer flexiblen Tragstruktur mit einer Rückseite und einer Vorderseite und mit daran zumindest auf der Vorderseite angeordneten Leuchtmitteln in der Form von Leuchtdioden und einer die Tragstruktur zumindest abschnittsweise im Bereich der Leuchtdioden überspannenden lichtdurchlässigen Abdeckung, wobei die Abdeckung flexibel ausgebildet ist.

Durch die Ausbildung der Leuchte mit einer flexiblen Abdeckung wird einerseits erreicht, dass die Leuchte an eine Vielzahl von Anwendungsmöglichkeiten in und am Fahrzeug angepasst werden kann und andererseits eine ausgesprochen kostengünstige Möglichkeit der nachträglichen Anbringung der Leuchte an einem Auflieger oder Trailer oder dergleichen möglich ist. Dadurch können auch bereits bestehende Fahrzeuge an lichttechnische Vorschriften nachträglich angepasst werden.

Da Fahrzeuge oft einem rauen Betrieb ausgesetzt sind und dies auch die Langzeitstabilität der elektrischen Beleuchtung des Fahrzeugs betrifft, ist es nach einer Weiterbildung der Erfindung vorgesehen, dass die Abdeckung die Leuchtdioden zwischen der Vorderseite der Tragstruktur und der Umgebung hermetisch dicht abschließt. Unter der Umgebung wird dabei die Fahrzeugumgebung verstanden, die Abdeckung schließt also die Leuchtdioden auf der Tragstruktur gegenüber Schmutz, Wasser, Eis und Staub und dergleichen, denen das Fahrzeug im Betrieb ausgesetzt ist, hermetisch ab, so dass einerseits die Leuchtdioden selbst und andererseits auch eine die Leuchtdioden mit elektrischer Energie versorgende Leitungsanordnung geschützt ist.

Es ist dabei nach einer Weiterbildung der Erfindung vorgesehen, dass die Abdeckung in der Form eines zumindest im Bereich der Leuchtdioden transparenten Materials auf der Vorderseite der Tragstruktur angeordnet und mit der Tragstruktur verbunden ist derart, dass das Eindringen von Feuchtigkeit in den Bereich zwischen dem Material und der Tragstruktur vermieden ist.

Zum hermetisch dichten Abschließen der Leuchtmittel und der Leitungsstruktur oder Leitungsanordnung sieht die Erfindung vor, dass die Abdeckung mit der Tragstruktur stoffschlüssig verbunden ist oder mittels eines thermischen Fügeverfahrens mit der Tragstruktur stoffschlüssig verbunden ist. In beiden Fällen kann dabei die Abdeckung während der Applikation auf der Tragstruktur auch mittels Druckbeaufschlagung zur Beseitigung und/oder Vermeidung von Lufteinschlüssen zwischen der Tragstruktur und der Abdeckung bearbeitet werden.

Die Abdeckung kann beispielsweise in der Form eines transparenten oder diffus streuenden Vergussmaterials auf die Tragstruktur aufgebracht werden, welches dauerhaft elastisch bleibt und so die Leuchtdioden hermetisch einschließt und die Abdeckung mit der Tragstruktur stoffschlüssig verbunden wird. Das Vergussmaterial schmiegt sich dabei an die Leuchtdioden an und schließt diese vollständig ein und schirmt sie so gegen die Umgebung hermetisch dicht ab. Aufgrund der Elastizität des Vergussmaterials kann es auch Formänderungen ausgleichen, denen die Leuchte beispielsweise aufgrund von Temperaturschwankungen und Erschütterungen beim Fahrbetrieb des Fahrzeugs ausgesetzt ist.

Das Aufbringen des Vergussmaterials kann beispielsweise durch einen Spritzvorgangs oder Einformvorgang erfolgen, so dass das Vergussmaterial die Leuchtmittel oder Leuchtdioden allseitig umschließt und so für einen Schutz der Leuchtdioden und der an diese heran geführte elektrisch kontaktierende Leitungsanordnung sorgt.

Es ist dabei nach einer Weiterbildung der Erfindung auch vorgesehen, dass die Abdeckung in der Form einer Anordnung mit einer als flexibles elastisches Band ausgebildeten Tragstruktur vorgesehen ist, an dem die Leuchtdioden in vorbestimmten Abständen angeordnet und von der Abdeckung eingeschlossen sind.

Dies macht es möglich, die Leuchte in der Form eines Leuchtbands vorzusehen, welches in für den jeweiligen Anwendungsfall am Fahrzeug geeigneter Länge abgelängt werden kann, so dass eine fahrzeugspezifisch aufwendige Fertigung der Leuchten entfällt. Das abgelängte Leuchtband muss dann nur mehr mit einer Anschlußstruktur versehen werden, die mit einer Leitungsanordnung zur Spannungs- und Stromversorgung der Leuchtdioden verbunden wird, so dass die elektrische Energieversorgung der Leuchtdioden erreicht ist. Nach dem Ablängen des Leuchtbands und dem Anbringen der Anschlußstruktur kann das Leuchtband dann auf die Fahrzeugstruktur aufgebracht werden.

Es ist dabei erfindungsgemäß vorgesehen, dass die Tragstruktur Leitungsmittel zur elektrischen Kontaktierung der daran angeordneten Leuchtdioden aufweist und mit den Leitungsmitteln elektrisch verbundene Kontaktierungsbauteile besitzt. Bei den Leitungsmitteln kann es sich beispielsweise um Leiterbahnen handeln, an denen die einzelnen Leuchtdioden angeschlossen sind und die Leiterbahnen an der Tragstruktur angeordnet sind. Über eine Kontaktierung der Leiterbahnen mit an die Leiterbahnen herangeführten Spannungsversorgungsleitungen in der Form einer Leitungsanordnung, in die an der Tragstruktur vorgesehene Kontaktierungsbauteile in der Form von beispielsweise Schneidkontakten einschneiden und somit eine elektrisch leitende Verbindung zwischen den Leuchtdioden und den Spannungsversorgungsleitungen hergestellt wird, können einzelne, eine vorbestimmte Länge aufweisende Segmente der Tragstruktur mit daran angeordneten Leuchtdioden mit elektrischer Energie versorgt werden. Über die Anordnung solcher Schneidkontakte in regelmäßigen Abständen an der Tragstruktur können verschiedene vorbestimmbare Längen aufweisende Segmente der Tragstruktur mit daran angeordneten Leuchtdioden bereitgestellt werden, um den jeweiligen Anwendungsfällen entsprechende Längen von erfindungsgemäßen Leuchten bereitstellen zu können.

Da die erfindungsgemäße Leuchte für den Betrieb an einem Fahrzeug unter rauen Umgebungsbedingungen vorgesehen ist und die Leuchtdioden und die gesamte Leitungsanordnung zur Spannungsversorgung der Leuchtdioden hermetisch gegen diese rauen Umgebungsbedingungen geschützt werden müssen, ist es erfindungsgemäß auch vorgesehen, dass die Tragstruktur in einer elastisch ausgebildeten, lang gestreckten Aufnahme angeordnet ist und die Aufnahme eine Basis und sich von der Basis im Winkel wegerstreckende und mit der Basis einstückig ausgebildete Seitenflächen besitzt und die Aufnahme eine im Querschnitt kanalförmige Ausbildung aufweist.

Durch die Anordnung der Tragstruktur in der kanalförmigen Aufnahme wird bereits ein Schutz der Tragstruktur von drei Längsseiten her erreicht, nämlich von unten durch die Basis und durch die beiden Seitenflächen der Aufnahme jeweils seitlich. Durch das Aufbringen der flexiblen Abdeckung von oben her wird schließlich eine weitere Seite der Tragstruktur gegen die Umweltbedingungen geschützt.

Da neben der Tragstruktur auch die elektrische Spannungsversorgung für die Leuchtdioden gegen die Umweltbedingungen geschützt werden soll, ist es erfindungsgemäß auch vorgesehen, dass im Bereich zwischen der Tragstruktur und der Basis der Aufnahme die die Spannungsversorgung sicherstellende Leitungsanordnung angeordnet ist, welche mindestens zwei Leitungen aufweist, die mit den Kontaktierungsbauteilen elektrisch leitfähig verbunden sind. Neben den beiden Leitungen können auch weitere Leitungen vorgesehen sein, beispielsweise Steuerleitungen für die Signal- und/oder Datenübertragung zu Steuereinrichtungen am Fahrzeug.

Durch die Anordnung der Leitungsanordnung im Bereich zwischen der Tragstruktur und der Basis wird die Leitungsanordnung von oben her durch die Tragstruktur geschützt, die wiederum von der flexiblen Abdeckung geschützt ist, sodass ein Schutz der Leitungsanordnung auch durch die flexible Abdeckung erreicht wird.

Es ist dabei erfindungsgemäß auch vorgesehen, dass die Abdeckung in der Form eines die Leitungsanordnung und die Tragstruktur einschließenden flexiblen Körpers ausgebildet ist, der eine in Richtung der Seitenflächen der Aufnahme verlaufende Höhenerstreckung besitzt. Der flexible Körper kann sich dabei über die gesamte Höhe der Seitenflächen erstrecken oder auch weniger hoch ausgebildet sein als die Seitenflächen.

Der flexible Körper kann durch das Einbringen des vorstehend erwähnten elastischen Vergussmaterials in die Aufnahme ausgebildet werden, sodass also in die Aufnahme zunächst die Leitungsanordnung eingebracht wird, auf der dann die Tragstruktur mit den Leuchtdioden aufgebracht wird und der so erzeugte Aufbau durch das Einbringen von Vergussmaterial in den Innenraum der Aufnahme vollständig vergossen wird.

Diese Konfiguration führt in vorteilhafter Weise dazu, dass die Aufnahme gleichzeitig als Form zur Ausbildung des elastischen Körpers genutzt wird, der die flexible Abdeckung ausbildet und so die flexible Tragstruktur mit den daran angeordneten Leuchtdioden und der flexiblen Abdeckung in der elastischen Aufnahme verbleiben kann und ein Ausformen des Aufbaus aus der Form entfallen kann, die dann gleichzeitig zur Anordnung der so geschaffenen Konfiguration am Anbringungsort für die erfindungsgemäße Leuchte dient. Bei dem Anbringungsort kann es sich beispielsweise um die Seitenwand eines Trailers oder dergleichen handeln, an dem der so hergestellte Leuchtenaufbau angebracht werden kann, beispielsweise also in eine Nut der Seitenwand des Trailers eingesetzt werden kann, sodass der Leuchtenaufbau mit der Seitenwand bündig abschließt.

Es ist dabei nach einer Weiterbildung der Erfindung auch vorgesehen, dass die Seitenflächen an der zur Basis zugewandten Innenseite und/oder an der von der Basis abgewandten Außenseite jeweils mindestens eine in Längsrichtung der Seitenflächen verlaufende Rippe aufweisen. Durch die Anbringung der Rippe an der Innenseite der Seitenfläche wird erreicht, dass der elastische Körper in der Aufnahme eine formschlüssige Festlegung erfährt und durch die Anbringung der Rippe an der Außenseite der Seitenflächen der Aufnahmen wird erreicht, dass der so gebildete Aufbau oder Leuchtenaufbau aus Aufnahme und im Innenraum der Aufnahme angeordneter Tragstruktur mit Leitungsanordnung und elastischem Körper in eine Nut am Anbringungsort der erfindungsgemäßen Leuchte eingesetzt werden kann und der Aufbau durch die Rippen an den Außenseiten der Seitenflächen eine Montagesicherung in der Nut erfährt, also beispielsweise an den Seitenwänden eines Aufliegers oder Trailers eines Sattelschleppers angeordneter Nuten, in denen abgelängte Segmente des geschilderten Aufbaus zur Ausbildung von beispielsweise Konturmarkierungsleuchten eingebracht werden.

Es ist nach einer Weiterbildung der Erfindung auch vorgesehen, dass die Aufnahme eine mit den Seitenflächen einstückig ausgebildete Oberseite aufweist und die Aufnahme im Querschnitt einen an den Längsseiten geschlossenen Kanal ausbildet. Damit weist die Aufnahme eine Konfiguration ähnlich einer rechteckförmigen Hülle auf, in welche ein abgelängtes Segment der Tragstruktur mit daran angeordneten Leuchtdioden eingebracht werden kann und in den Innenraum der Hülle dann Vergussmaterial eingebracht wird, welches die Tragstruktur mit daran angeordneten Leuchtdioden hermetisch einschließt und so gegen die vorstehend erwähnten rauen Umgebungsbedingungen schützt.

Bevor das Vergussmaterial eingebracht wird, kann an einem stirnseitigen Ende eine Anschlussstruktur mit beispielsweise zwei Leitungen zur Verbindung mit an den Leitungsmitteln der Tragstruktur vorgesehenen Schneidkontakten eingebracht werden und die so geschaffene Konfiguration dann durch das Einbringen von Vergussmaterial geschützt werden.

Alternativ hierzu ist es auch möglich, in den Innenraum des geschlossenen kanalförmigen Aufbaus ein Segment der Tragstruktur mit Leuchtdioden zusammen mit einer Leitungsanordnung zwischen der Tragstruktur und der Basis des Aufbaus einzubringen, sodass die an der Tragstruktur vorgesehenen Kontaktierungsbauteile, beispielsweise Schneidkontakte, mit der Leitungsanordnung in Kontakt kommen und somit eine elektrische Verbindung zwischen den Leuchtdioden an der Tragstruktur und der Leitungsanordnung zustande kommt, die beispielsweise an eine externe Spannungsversorgung des Fahrzeugs angeschlossen werden kann. Nach dem Einbringen von Vergussmaterial in den Innenraum wird dann neben der Tragstruktur mit den daran angeordneten Leuchtdioden auch die Leitungsanordnung durch das Vergussmaterial hermetisch geschützt.

Es ist nach einer Weiterbildung der Erfindung auch vorgesehen, dass die Anordnung mit der Aufnahme und der Tragstruktur sowie der daran angeordneten Leuchtdioden und der Abdeckung in der Form beispielsweise des elastischen Körpers in der Form einer Rolle oder Spule aufgewickelt vorliegt.

Wird dann ein Segment einer Leuchte benötigt, dann kann das eine vorbestimmte Länge aufweisende Segment von der Rolle oder Spule abgelängt werden und beispielsweise an einem stirnseitigen Ende mit einer Anschlussstruktur versehen werden, die eine elektrische Verbindung zwischen den Leitungsmitteln und/oder der Leitungsanordnung und somit zu den an der Tragstruktur angeordneten Leuchtdioden herstellt. Dadurch, dass die aus einem elastischen Vergussmaterial gebildete Abdeckung flexibel ausgebildet ist und auch die Tragstruktur mit den daran angeordneten Leuchtdioden flexibel ausgebildet ist und auch die Aufnahme, die beispielsweise aus einem thermoplastischen Polyurethan oder aus einem thermoplastischen Elastomer gebildet ist, flexibel ausgebildet ist, lässt sich die gesamte Anordnung in Rollenform auf beispielsweise einer Trommel oder Spule aufwickeln, von der dann eine vorbestimmte Länge der Anordnung zur Bildung der erfindungsgemäßen Leuchte abgelängt werden kann.

Die erfindungsgemäße Leuchte weist also die Konfiguration eines bandförmigen Körpers mit Leuchtdioden an vorbestimmten Bereichen auf, und kann als Leuchtband zur Markierung der Kontur eines Aufliegers und/oder Koffers und/oder Trailers und/oder Anhängers eines Fahrzeugs verwendet werden und kann zu diesem Zweck auch abschnittsweise an der Außenseite mit einer reflektierenden Anordnung versehen sein, wodurch die Kontur einerseits durch die Leuchtdioden erkennbar ist und andererseits auch über die reflektierende Anordnung in der Form beispielsweise von Segmenten einer Reflexionsfolie.

Die erfindungsgemäße Leuchte kann auch in der Form eines bandförmigen Körpers mit Leuchtdioden an vorbestimmten Bereichen des Körpers als Leuchtband zur Innenbeleuchtung eines Aufliegers und/oder Koffers und/oder Trailers und/oder Anhängers eines Fahrzeugs ausgebildet sein.

Die erfindungsgemäße Leuchte kann nach einer Weiterbildung der Erfindung auch in der Form eines bandförmigen Körpers mit Leuchtdioden an vorbestimmten Bereichen des Körpers ausgebildet und als Leuchtband zur Anordnung an zumindest einem Abschnitt eines Aufliegers und/oder Koffers und/oder Trailers und/oder Anhängers eines landwirtschaftlichen Fahrzeugs zur Anzeige eines Spurwechsels oder Abbiegevorgangs des landwirtschaftlichen Fahrzeugs durch intermittierendes Leuchten der Leuchtdioden ausgebildet sein.

Schließlich ist es nach einer Weiterbildung der Erfindung auch vorgesehen, dass die Aufnahme eine zumindest abschnittsweise lichtdurchlässige Struktur aufweist und mit einem thermoplastischen Kunststoffwerkstoff ausgebildet ist. Es kann also sowohl die Aufnahme als auch die Abdeckung in der Form beispielsweise des vorstehend erwähnten elastischen Körpers zumindest abschnittsweise lichtdurchlässig ausgebildet sein, wobei unter dem Begriff der Lichtdurchlässigkeit auch eine diffuse Lichtdurchlässigkeit verstanden wird, die Abdeckung und/oder die Aufnahme also opaque oder auch milchig erscheint, sodass das Leuchtband insgesamt oder zumindest an den Stellen der Anordnung der Leuchtdioden transparent oder teiltransparent erscheint.

Die Erfindung wird im folgenden anhand der Zeichnung näher erläutert. Diese zeigt in:
Fig. 1 eine Explosionsdarstellung eines Abschnitts einer Leuchte nach einer ersten Ausführungsform;
Fig. 2 eine Schnittdarstellung des Aufbaus der Leuchte nach Fig.1 im zusammengebauten Zustand;
Fig. 3 eine perspektivische Darstellung einer Leuchte nach der Ausführungsform gemäß Fig. 1;
Fig. 4 eine Explosionsdarstellung eines Abschnitts einer Leuchte nach einer weiteren Ausführungsform mit einer kanalförmigen und an den Längsseiten geschlossenen Aufnahme;
Fig. 5 eine perspektivische schematische Darstellung eines als Sattelschlepper ausgeführten Lastkraftwagens mit einem Trailer mit an den Seitenwänden und der Rückwand angeordneten Leuchten;
Fig. 6 eine schematische Längsschnittdarstellung einer Dachbox für einen Personenkraftwagen mit am Deckel der Dachbox innen angeordneter Leuchte nach der vorliegenden Erfindung; und
Fig. 7 eine schematische Schnittansicht eines Kühlkoffers eines Fahrzeugs zur Beförderung von Lebensmitteln mit an der Decke des Kühlkoffers angeordneten Leuchten.

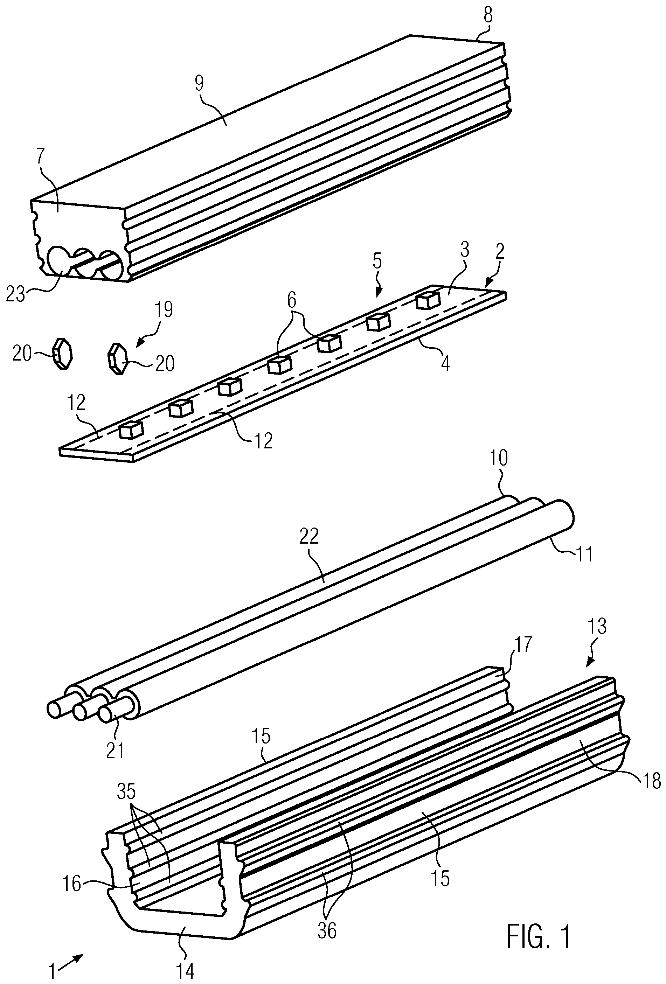

Fig. 1 der Zeichnung zeigt eine erste Ausführungsform einer Leuchte 1 für Fahrzeuge in eine Explosionsdarstellung.

Die Leuchte 1 weist eine Tragstruktur 2 mit einer Vorderseite 3 und einer Rückseite 4 auf. An der Vorderseite 3 sind mehrere Leuchtmittel 5 in der Form von Leuchtdioden LEDs 6 angeordnet. Die Leuchte 1 weist darüber hinaus eine Abdeckung 7 auf, die bei der dargestellten Ausführungsform von einem elastischen Körper 8 gebildet wird, welcher aus einem transparenten Vergussmaterial 9 gebildet wird.

Die Leuchte 1 weist darüber hinaus eine Leitungsanordnung 10 auf, die bei der dargestellten Ausführungsform aus drei einzelnen Leitungsadern 11 gebildet sind, von denen zwei Leitungsadern der Strom- und Spannungsversorgung der Leuchtdioden 6 dienen und eine dritte Leitungsader der Signalübertragung an eine nicht näher dargestellte Steuereinrichtung dient.

An der Vorderseite 3 der Tragstruktur 2 sind zwei lediglich schematisch dargestellte Leitungsmittel 12 in der Form von Leitungsbahnen vorgesehen, die der Spannungsversorgung der einzelnen Leuchtdioden 6 dienen.

Eine lang gestreckte Aufnahme 13 weist eine Basis 14 und zwei Seitenflächen 15 auf, die sich bei der dargestellten Ausführungsform der Aufnahme 13 im rechten Winkel von der Basis 14 weg erstrecken und zwischen den Seitenflächen 15 und der Basis 14 ein Innenraum 16 ausgebildet wird, welcher der Aufnahme der Leitungsanordnung 10 und der Tragstruktur 2 sowie des elastischen Körpers 8 dient.

Wie es ohne weiteres ersichtlich ist, besitzen die Seitenflächen 15 sowohl an der Innenseite 17 als auch an der Außenseite 18 längs verlaufende Rippen 35, 36. Die innen liegenden Rippen 35 dienen dabei der zusätzlichen formschlüssigen Festlegung des elastischen Körpers 8 im Innenraum 16 und die außen liegenden Rippen 36 dienen der zusätzlichen formschlüssigen Festlegung der Leuchte 1 am Montageort, also beispielsweise einer Nut oder einer Aluminiumsschiene einer Seitenwand eines Trailers eines Fahrzeugs, wenn die erfindungsgemäße Leuchte 1 beispielsweise als Konturmarkierungsleuchte für das Fahrzeug dient.

Zur Ausbildung der Leuchte 1 wird in den Innenraum 16 der Aufnahme 13 die Leitungsanordnung 10 eingebracht und sodann die Tragstruktur 2 darauf angeordnet. Die Leitungsmittel 12 sind mit Kontaktierungsbauteilen 19 in der Form von Schneidkontakten 20 versehen, welche sich bei der Anordnung der Tragstruktur 2 auf der Leitungsanordnung 10 durch die isolierende Umhüllung der Leitungsadern 11 hindurch schneiden und damit einen elektrisch leitenden Kontakt mit den beispielsweise aus einem Kupferwerkstoff bestehenden Kabellitzen 21 herstellen.

Nachdem der so gebildete Aufbau aus Aufnahme 13 und Leitungsanordnung 10 sowie Tragstruktur 2 im Innenraum 16 angeordnet worden ist, kann ein Vergussmaterial 9 auf den so gebildeten Aufbau aufgebracht werden, welches dann den elastischen Körper 8 ausbildet, der gleichzeitig als flexible Abdeckung 7 dient und die Tragstruktur 2 mit den daran angeordneten Leuchtdioden 6 und die Leitungsmittel 12 sowie die Leitungsanordnung 10 hermetisch gegen Schmutz, Staub, Feuchtigkeit und dergleichen schützt.

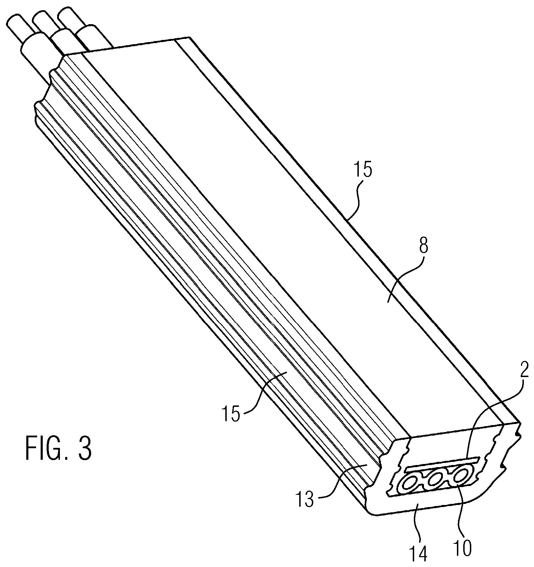

Fig. 3 zeigt ein Segment oder einen Abschnitt einer Leuchte 1, welche nach der vorbeschriebenen Methode fertig gestellt wurde. In der Aufnahme 13 befindet sich die Leitungsanordnung 10 auf der Basis 14 angeordnet und darüber befindet sich die Tragstruktur 2 mit den in Fig. 3 nicht näher dargestellten Leuchtdioden 6 angeordnet. Die Seitenflächen 15 schließen dabei den elastischen Körper 8 seitlich ein und die Leuchte 1 kann beispielsweise in einer Nut einer Seitenwand eines Trailers angeordnet werden, um als Konturmarkierungsleuchte zu dienen.

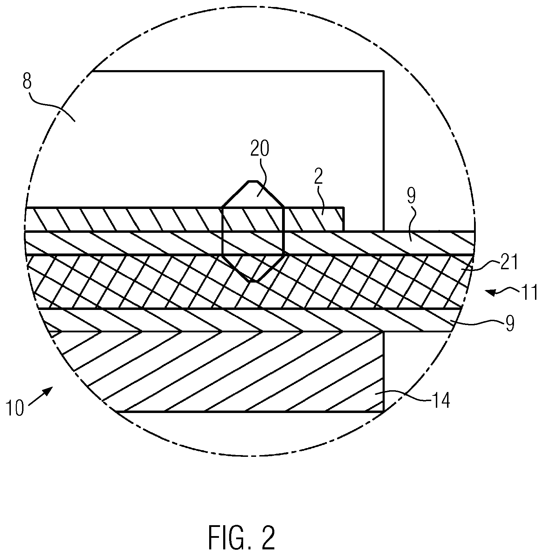

Fig. 2 der Zeichnung zeigt eine Querschnittsdarstellung der Leuchte 1 nach Fig. 1 der Zeichnung.

Auf der Basis 14 werden die Leitungsanordnung 11 der Leitungsanordnung 10 angeordnet und der Schneidkontakt 20 durchschneidet die isolierende Umhüllung 22 der Leitungsader 11, sodass der Schneidkontakt 20 mit der spannungsführenden Kabellitze 21 in Kontakt kommt. Die Tragstruktur 2 befindet sich auf der Leitungsanordnung 10 angeordnet und das Vergussmaterial 9 umschließt sowohl die Leitungsadern 11 als auch die Tragstruktur 10 und füllt den Innenraum 16 der Aufnahme 13 vollständig aus. Es bedeutet dies, dass das Vergussmaterial 9 auch die im Querschnitt runde Umhüllung 22 der Leitungsadern 11 umschließt, was in Fig. 1 der Zeichnung mit den längs verlaufenden Kanälen 23 im elastischen Körper 8 angedeutet ist.

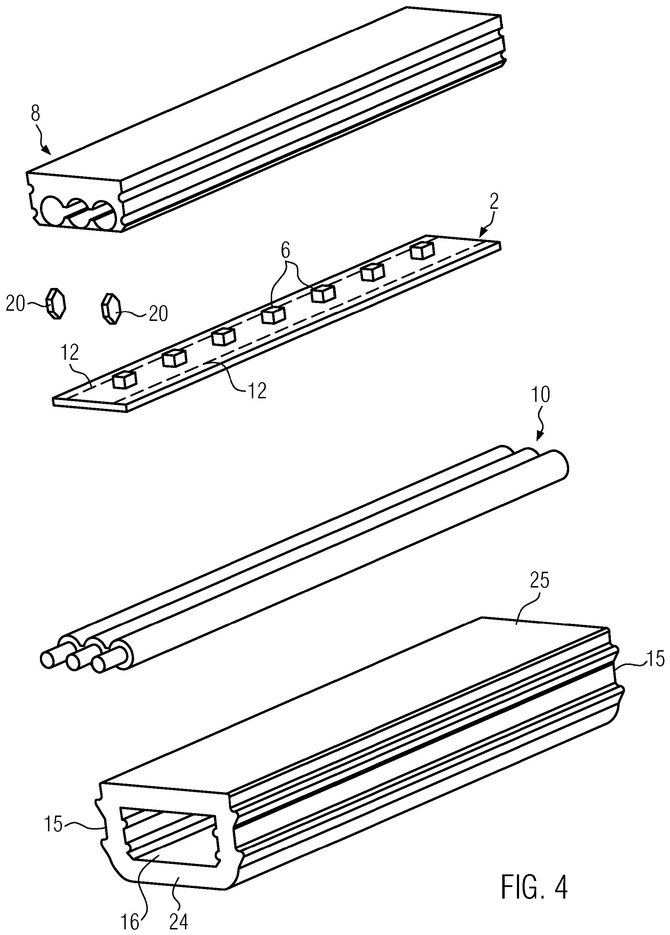

Die in Fig. 4 der Zeichnung dargestellte Ausführungsform der Leuchte 1 unterscheidet sich von der in Fig. 1 dargestellten Ausführungsform dadurch, dass die dort dargestellte Aufnahme 24 eine mit den Seitenflächen 15 einstückig ausgebildete Oberseite 25 aufweist, sodass die Aufnahme 24 im Querschnitt einen Kanal ausbildet, welcher an allen Längsseiten geschlossen ist.

Nach der Anordnung der Leitungsanordnung 10 und der Tragstruktur 2 im Innenraum 16 der Aufnahme 24 kann der Innenraum 16 vollständig mit Vergussmaterial 9 aufgefüllt werden, um den transparenten elastischen Körper 8 auszubilden, sodass das von den Leuchtdioden 6 emittierte Licht durch den elastischen Körper 8 beispielsweise diffus gestreut wird und über die transparente oder teiltransparent die Oberseite 25 der Aufnahme 24 nach außen abgestrahlt wird, um beispielsweise wiederum der Konturmarkierung eines Trailers eines Fahrzeugs zu dienen.

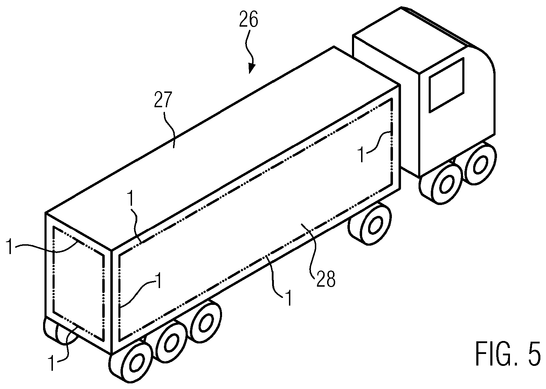

Fig. 5 der Zeichnung zeigt einen exemplarischen Anwendungsfall für die Verwendung der Leuchte 1. Die Fig. 5 zeigt eine schematische Darstellung eines Sattelschleppers 26 mit einem Trailer oder Sattelauflieger 27, an dessen Seitenwänden 28 und der Rückwand 29 die Leuchte 1 zur Markierung der Kontur des Sattelaufliegers 27 festgelegt wurde. In das Leuchtband 1 können auch LEDs 6 integriert sein, die beim Fahrtrichtungswechsel des Fahrzeugs oder Sattelschleppers 26 intermittierend leuchten, also blinken.

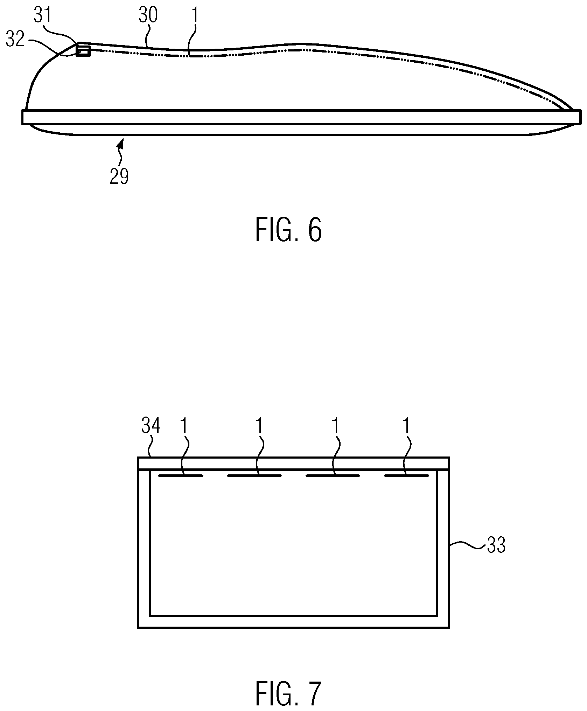

Fig. 6 der Zeichnung zeigt eine schematische Längsschnittansicht einer Dachbox 29, die an einem nicht näher dargestellten Personenkraftwagen angeordnet werden kann und einen Deckel 30 aufweist, an dessen Innenseite die Leuchte 1 mittels einer Haftklebeverbindung oder einer Klettverschlussverbindung festgelegt worden ist. Obwohl bei der dargestellten Ausführungsform die Leuchte 1 über nahezu die gesamte Länge des Deckels 30 dargestellt ist, kann es in Abhängigkeit der Leuchtstärke der bei der Leuchte 1 verwendeten LEDs 6 auch ausreichend sein, nur einen kurzen streifenförmigen Abschnitt der Tragstruktur 2 mit daran angeordneten LEDs 6 am Deckel 30 innen festzulegen. Da die LEDs 7 nur wenig Energie verbrauchen, ist zu deren Energieversorgung am Deckel 28 innen ein Gehäuse 31 mit darin angeordneten Batterien oder Akkus 30 vorgesehen, die die Energie für die Beleuchtung des Innenraums der Dachbox 27 bereitstellen, so dass der Benutzer der Dachbox 29 den darin aufgenommenen Inhalt auch bei Dunkelheit genau sehen kann.

Fig. 7 der Zeichnung zeigt eine schematische Schnittdarstellung eines Kühlkoffers 33 eines Fahrzeugs zur Beförderung von Lebensmitteln. Der Kühlkoffer 31 weist eine Decke 34 auf, an der im Abstand zueinander angeordnete Leuchten 1 nach der vorliegenden Erfindung angeordnet sind. Obwohl bei der in Fig. 7 dargestellten Ausführungsform vier einzelne Leuchten 1 im Abstand zueinander angeordnet sind, die jeweils mit nicht näher dargestellten Energieversorgungsleitungen untereinander verbunden sind und über das Bordnetz des Fahrzeugs mit Energie versorgt werden, kann anstelle der vier einzelnen Leuchten 1 auch nur eine Leuchte 1 an der Decke 34 festgelegt werden, welche die gesamte oder weitgehend gesamte Innenlänge des Kühlkoffers 33 überspannt und jeweils im Abstand zueinander angeordnete Leuchtmittel 5 oder LEDs 6 aufweist und zwar in Abhängigkeit von der benötigten Helligkeit oder der Leuchtstärke der Leuchtmittel 5 oder LEDs 6.

Hinsichtlich vorstehend im einzelnen nicht näher erläuterter Merkmale der Erfindung wird im übrigen ausdrücklich auf die Ansprüche und die Zeichnung verwiesen.

### Bezugszeichenliste

- 1.: Leuchte
- 2.: Tragstruktur
- 3.: Vorderseite
- 4.: Rückseite
- 5.: Leuchtmittel
- 6.: Leuchtdioden
- 7.: Abdeckung
- 8.: elastischer Körper
- 9.: Vergussmaterial
- 10.: Leitungsanordnung
- 11.: Leitungsader
- 12.: Leitungsmittel
- 13.: Aufnahme
- 14.: Basis
- 15.: Seitenfläche
- 16.: Innenraum
- 17.: Innenseite
- 18.: Außenseite
- 19.: Kontaktierungsbauteile
- 20.: Schneidkontakte
- 21.: Kabellitzen
- 22.: isolierende Umhüllung
- 23.: Kanal
- 24.: Aufnahme
- 25.: Oberseite
- 26.: Sattelschlepper
- 27.: Trailer
- 28.: Seitenwand
- 29.: Dachbox
- 30.: Deckel
- 31.: Gehäuse
- 32.: Batterien
- 33.: Kühlkoffer
- 34.: Decke
- 35.: Rippe
- 36.: Rippe

## Patentansprüche

1. Leuchte (1) für Fahrzeuge, mit einer flexiblen Tragstruktur (2) mit einer Rückseite (4) und einer Vorderseite (3) und mit daran zumindest auf der Vorderseite (3) angeordneten Leuchtmitteln (5) in der Form von Leuchtdioden (6) und einer die Tragstruktur (2) zumindest abschnittsweise im Bereich der Leuchtdioden (5) überspannenden lichtdurchlässigen flexiblen Abdeckung (8), wobei die Tragstruktur (2) als flexibles elastisches Band ausgebildet ist und Leitungsmittel (12) zur elektrischen Kontaktierung der daran angeordneten Leuchtdioden (6) aufweist und mit den Leitungsmitteln (12) elektrisch verbundene Kontaktierungsbauteile (19) besitzt, **dadurch gekennzeichnet dass**
die Tragstruktur (2) in einer elastisch ausgebildeten, langgestreckten Aufnahme (13, 24) angeordnet ist und die Aufnahme (13, 24) eine Basis (14) und sich von der Basis (14) im Winkel wegerstreckende und mit der Basis (14) einstückig ausgebildete Seitenflächen (15) besitzt, und die Aufnahme (13, 24) eine im Querschnitt kanalförmige Ausbildung aufweist, wobei im Bereich zwischen der Tragstruktur (2) und der Basis (14) der Aufnahme (13, 24) eine Leitungsanordnung (10) angeordnet ist und die Leitungsanordnung (10) mindestens zwei Kabellitzen (21) aufweist, die mit den Kontaktierungsbauteilen (19) elektrisch leitfähig verbunden sind und die Abdeckung (8) in der Form eines die Leitungsanordnung (10) und die Tragstruktur (2) einschließenden flexiblen Körpers (8) ausgebildet ist, der eine in Richtung der Höhenerstreckung der Seitenflächen (15) der Aufnahme (13, 24) verlaufende Höhenerstreckung besitzt.

2. Leuchte (1) für Fahrzeuge nach Anspruch 1, **dadurch gekennzeichnet, dass** die Abdeckung (8) die Leuchtdioden (6) zwischen der Vorderseite (3) der Tragstruktur (2) und der Umgebung hermetisch dicht abschließt.

3. Leuchte (1) für Fahrzeuge nach Anspruch 1 oder 2, **dadurch gekennzeichnet, dass** die Abdeckung (8) in der Form eines zumindest im Bereich der Leuchtdioden (6) transparenten Materials auf der Vorderseite (3) der Tragstruktur (2) angeordnet und mit der Tragstruktur (2) verbunden ist derart, dass das Eindringen von Feuchtigkeit in den Bereich zwischen Material und Tragstruktur (2) vermieden ist.

4. Leuchte (1) für Fahrzeuge nach einem der vorstehenden Ansprüche, **dadurch gekennzeichnet, dass** die Leuchte (1) für Fahrzeuge in der Form einer Anordnung vorgesehen ist, bei der die Leuchtdioden (6) in vorbestimmten Abständen an der Tragstruktur (2) angeordnet und von der Abdeckung (8) eingeschlossen sind.

5. Leuchte (1) für Fahrzeuge nach Anspruch 4, **dadurch gekennzeichnet, dass** die Seitenflächen (15) an der zur Basis (14) zugewandten Innenseite (17) und/oder an der von der Basis (14) abgewandten Außenseite (18) jeweils mindestens eine in Längsrichtung der Seitenflächen (15) verlaufende Rippe (35, 36) aufweisen.

6. Leuchte (1) für Fahrzeuge nach Anspruch 5, **dadurch gekennzeichnet, dass** die Aufnahme (24) eine mit den Seitenflächen (15) einstückig ausgebildete Oberseite (25) aufweist und die Aufnahme (24) im Querschnitt einen an den Längsseiten geschlossenen Kanal ausbildet.

7. Leuchte (1) für Fahrzeuge nach einem der Ansprüche 4 bis 6, **dadurch gekennzeichnet, dass** die Anordnung in der Form einer Rolle oder Spule aufgewickelt ist und in vorbestimmbarer Länge ablängbar ist.

8. Leuchte (1) für Fahrzeuge nach einem der vorstehenden Ansprüche, **dadurch gekennzeichnet, dass** die Leuchte (1) für Fahrzeuge in der Form eines bandförmigen Körpers mit Leuchtdioden (6) an vorbestimmten Bereichen des Körpers ausgebildet ist und als Leuchtband zur Markierung der Kontur eines Aufliegers und/oder Koffers und/oder Trailers und/oder Anhängers eines Fahrzeugs ausgebildet ist und das Leuchtband zumindest abschnittsweise an der Außenseite mit einer reflektierenden Anordnung versehen ist.

9. Leuchte (1) für Fahrzeuge nach einem der vorstehenden Ansprüche, **dadurch gekennzeichnet, dass** die Leuchte (1) für Fahrzeuge in der Form eines bandförmigen Körpers mit Leuchtdioden (6) an vorbestimmten Bereichen des Körpers ausgebildet ist und als Leuchtband zur Innenbeleuchtung eines Aufliegers und/oder Koffers und/oder Trailers und/oder Anhängers eines Fahrzeugs ausgebildet ist.

10. Leuchte (1) für Fahrzeuge nach einem der vorstehenden Ansprüche, **dadurch gekennzeichnet, dass** die Leuchte (1) für Fahrzeuge in der Form eines bandförmigen Körpers mit Leuchtdioden an vorbestimmten Bereichen des Körpers ausgebildet ist und als Leuchtband zur Anordnung an zumindest einem Abschnitt eines Aufliegers und/oder Koffers und/oder Trailers und/oder Anhängers eines landwirtschaftlichen Fahrzeugs zur Anzeige eines Spurwechsels oder Abbiegevorgangs des landwirtschaftlichen Fahrzeugs durch intermittierendes Leuchten der Leuchtdioden ausgebildet ist.

11. Leuchte (1) für Fahrzeuge nach einem der vorstehenden Ansprüche, **dadurch gekennzeichnet, dass** die Aufnahme (13, 24) eine zumindest abschnittsweise lichtdurchlässige Struktur aufweist und mit einem thermoplastischen Kunststoffwerkstoff ausgebildet ist.

## Claims

1. Light (1) for vehicles, having a flexible support structure (2) having a back (4) and a front (3) and having light sources (5) in the form of light-emitting diodes (6) arranged thereon, at least on the front (3), and a flexible, light-permeable cover (8) that spans the support structure (2) at least in sections in the area of the light-emitting diodes (5), wherein the support structure (2) is designed as a flexible elastic band and has conduction means (12) for electrically contacting the light-emitting diodes (6) arranged thereon and possesses contacting components (19) that are electrically connected to the conduction means (12), **characterised in that**
the support structure (2) is arranged in an elastic, elongated holder (13, 24) and the holder (13, 24) has a base (14) and side surfaces (15) extending at an angle away from the base (14) and designed in a single piece with the base (14), and the holder (13, 24) has a channel-shaped cross-section, wherein a conduit configuration (10) is arranged in the area between the support structure (2) and the base (14) of the holder (13, 24) and the conduit configuration (10) has at least two cable strands (21), which are electrically connected to the contacting components (19) in a conductive manner, and the cover (8) is designed in the form of a flexible body (8) enclosing the conduit configuration (10) and the support structure (2), said body possessing a vertical extension extending in the direction of the vertical extension of the side surfaces (15) of the holder (13, 24).

2. Light (1) for vehicles according to claim 1, **characterised in that** the cover (8) hermetically seals the light-emitting diodes (6) between the front (3) of the support structure (2) and the environment.

3. Light (1) for vehicles according to claim 1 or 2, **characterised in that** the cover (8) is arranged in the form of a transparent material on the front (3) of the support structure (2), at least in the area of the light-emitting diodes (6), and is connected to the support structure (2) in such a way that moisture is prevented from penetrating the area between the material and the support structure (2).

4. Light (1) for vehicles according to one of the preceding claims, **characterised in that** the light (1) for vehicles is provided in the form of an arrangement in which the light-emitting diodes (6) are arranged with predetermined spacing-apart on the support structure (2) and are enclosed by the cover (8).

5. Light (1) for vehicles according to claim 4, **characterised in that** the side surfaces (15) each have at least one rib (35, 36) extending in the lengthwise direction of the side surfaces (15) on the inner side (17) facing the base (14) and/or on the outer side (18) facing away from the base (14).

6. Light (1) for vehicles according to claim 5, **characterised in that** the holder (24) has a top side (25) designed in a single piece with the side surfaces (15) and the holder (24) forms a channel that is closed at the sides in cross-section.

7. Light (1) for vehicles according to one of claims 4 to 6, **characterised in that** the arrangement is coiled in the form of a reel or coil and is to be cut to a predetermined length.

8. Light (1) for vehicles according to one of the preceding claims, **characterised in that** the light (1) for vehicles is designed in the form of a band-shaped body having light-emitting diodes (6) in predetermined areas of the body and is designed as an illumination band for marking the contour of a semi-trailer and/or box body and/or trailer and/or truck trailer of a vehicle and the illumination band is provided with a reflective arrangement, at least in sections on the outside.

9. Light (1) for vehicles according to one of the preceding claims, **characterised in that** the light (1) for vehicles is designed in the form of a band-shaped body having light-emitting diodes (6) in predetermined areas of the body and is designed as an illumination band for the interior lighting of a semi-trailer and/or box body and/or trailer and/or truck trailer of a vehicle.

10. Light (1) for vehicles according to one of the preceding claims, **characterised in that** the light (1) for vehicles is designed in the form of a band-shaped body having light-emitting diodes in predetermined areas of the body and is designed as a light band for arrangement on at least one section of a semi-trailer and/or box body and/or trailer and/or truck trailer of an agricultural vehicle to indicate a lane change or turning process of the agricultural vehicle by intermittent lighting of the light-emitting diodes.

11. Light (1) for vehicles according to one of the preceding claims, **characterised in that** the holder (13, 24) has structure that is light-permeable, at least in some sections, and is designed having a thermoplastic plastic material.

## Revendications

1. Luminaire (1) pour véhicules, comprenant une structure porteuse (2) flexible dotée d'une face arrière (4) et d'une face avant (3) et comprenant des moyens lumineux (5) sous la forme de diodes électroluminescentes (6) qui y sont disposés au moins sur la face avant (3), ainsi qu'un cache (8) flexible translucide recouvrant la structure porteuse (2) au moins par sections au niveau des diodes électroluminescentes (5), ladite structure porteuse (2) étant conçue sous la forme d'un ruban élastique flexible et présentant des moyens conducteurs (12) pour le contact électrique des diodes électroluminescentes (6) qui y sont disposées, et possédant des composants de contact (19) reliés électriquement aux moyens conducteurs (12) ;
**caractérisé en ce que** la structure porteuse (2) est disposée dans un réceptacle (13, 24) allongé de conception élastique, lequel réceptacle (13, 24) possède une base (14) et des surfaces latérales (15) solidaires de celle-ci et s'étendant de manière coudée en partant de ladite base (14), et le réceptacle (13, 24) présente une configuration dont la section transversale est en forme de canal, un dispositif conducteur (10) étant disposé dans la zone située entre la structure porteuse (2) et la base (14) du réceptacle (13, 24), lequel dispositif conducteur (10) présente au moins deux torons de câble (21) reliés électriquement aux composants de contact (19), et le cache (8) étant conçu sous la forme d'un corps flexible (8) qui renferme le dispositif conducteur (10) et la structure porteuse (2) et qui possède une étendue de hauteur dirigée le long de l'étendue de hauteur des surfaces latérales (15) du réceptacle (13, 24).

2. Luminaire (1) pour véhicules selon la revendication 1, **caractérisé en ce que** le cache (8) isole hermétiquement les diodes électroluminescentes (6) entre la face avant (3) de la structure porteuse (2) et l'environnement.

3. Luminaire (1) pour véhicules selon la revendication 1 ou 2, **caractérisé en ce que** le cache (8) est agencé, sous la forme d'un matériau qui est transparent au moins au niveau des diodes électroluminescentes (6), sur la face avant (3) de la structure porteuse (2) et est relié à la structure porteuse (2) de manière à éviter la pénétration d'humidité dans la zone située entre ledit matériau et la structure porteuse (2).

4. Luminaire (1) pour véhicules selon l'une des revendications précédentes, **caractérisé en ce que** le luminaire (1) pour véhicules est prévu sous la forme d'un dispositif dans lequel les diodes électroluminescentes (6) sont disposées à intervalles prédéterminés sur la structure porteuse (2) et sont enfermées par le cache (8).

5. Luminaire (1) pour véhicules selon la revendication 4, **caractérisé en ce que** les surfaces latérales (15) présentent, sur le côté intérieur (17) tourné vers la base (14) et/ou sur le côté extérieur (18) détourné de la base (14), au moins une nervure (35, 36) respective s'étendant dans le sens longitudinal des surfaces latérales (15).

6. Luminaire (1) pour véhicules selon la revendication 5, **caractérisé en ce que** le réceptacle (24) présente une surface supérieure (25) formée d'un seul tenant avec les surfaces latérales (15), et le réceptacle (24) forme, en section transversale, un canal qui est fermé sur les côtés longitudinaux.

7. Luminaire (1) pour véhicules selon l'une des revendications 4 à 6, **caractérisé en ce que** le dispositif est enroulé sous la forme d'un rouleau ou d'une bobine et peut être coupé à une longueur prédéterminée.

8. Luminaire (1) pour véhicules selon l'une des revendications précédentes, **caractérisé en ce que** le luminaire (1) pour véhicules est conçu sous la forme d'un corps en forme de ruban doté de diodes électroluminescentes (6) dans des zones prédéterminées du corps et est conçu sous la forme d'un ruban lumineux pour marquer le contour d'une semi-remorque et/ou d'un semi-remorque fourgon et/ou d'une remorque et/ou d'une remorque de camion d'un véhicule et le ruban lumineux est pourvu, au moins par sections sur la face extérieure, d'un dispositif réfléchissant.

9. Luminaire (1) pour véhicules selon l'une des revendications précédentes, **caractérisé en ce que** le luminaire (1) pour véhicules est conçu sous la forme d'un corps en forme de ruban pourvu de diodes électroluminescentes (6) en des zones prédéterminées du corps et est conçu sous la forme d'un ruban lumineux pour l'éclairage intérieur d'une semi-remorque et/ou d'un semi-remorque fourgon et/ou d'une remorque et/ou d'une remorque de camion d'un véhicule.

10. Luminaire (1) pour véhicules selon l'une des revendications précédentes, **caractérisé en ce que** le luminaire (1) pour véhicules est conçu sous la forme d'un corps en forme de ruban pourvu de diodes électroluminescentes en des zones prédéterminées du corps, et est conçu sous la forme d'un ruban lumineux à disposer sur au moins une section d'une semi-remorque et/ou d'un semi-remorque fourgon et/ou d'une remorque et/ou d'une remorque de camion d'un véhicule agricole pour indiquer un changement de voie ou une manœuvre de bifurcation du véhicule agricole par un clignotement des diodes électroluminescentes.

11. Luminaire (1) pour véhicules selon l'une des revendications précédentes, **caractérisé en ce que** le réceptacle (13, 24) présente une structure translucide, au moins par sections, et est constitué à l'aide d'un matériau synthétique thermoplastique.
